# EUROPÄISCHE PATENTSCHRIFT

(11) **EP 1 521 975 B1**
(45) Veröffentlichungstag und Bekanntmachung des Hinweises auf die Patenterteilung: **13.02.2008**
(21) Anmeldenummer: 03762433.5
(22) Anmeldetag: 01.07.2003
(51) Int. Cl.: G01R 33/30

(54) **HOCHAUFLÖSENDER NMR-PROBENKOPF FÜR GERINGE PROBENVOLUMINA SOWIE VERFAHREN ZUM BETRIEB**
HIGH RESOLUTION NMR PROBE HEAD FOR SMALL SAMPLE VOLUMES AND METHOD FOR OPERATING THE SAME
TETE DE SONDE DE MESURE DE RESONANCE MAGNETIQUE NUCLEAIRE A HAUTE RESOLUTION POUR FAIBLES VOLUMES D'ECHANTILLON ET PROCEDE POUR FAIRE FONCTIONNER CETTE TETE DE SONDE

(30) Priorität: 05.07.2002 DE 10230196
(43) Veröffentlichungstag der Anmeldung: 13.04.2005
(73) Patentinhaber: Fraunhofer-Gesellschaft zur Förderung der angewandten Forschung e.V., 80686 München (DE)
(72) Erfinder: VOLKE, Frank, 66386 St. Ingberg (DE); BENECKE, Martin, 66424 Homburg (DE)
(74) Vertreter: Gagel, Roland
(86) Internationale Anmeldenummer: PCT/DE2003/002184
(87) Internationale Veröffentlichungsnummer: WO 2004/005952

(56) Entgegenhaltungen:
- DE-A- 4 234 544
- US-A- 3 512 078
- US-A- 5 146 166
- US-A- 5 237 276
- US-A- 5 420 508

## Beschreibung

### Technisches Anwendungsgebiet

Die vorliegende Erfindung betrifft einen Probenkopf für NMR-Messungen in einem Magnetsystem, das eine parallel zu einem Grundmagnetfeld verlaufende Bohrung für die Aufnahme eines Probenkopfes aufweist, wobei sich der Probenkopf aus einem Trägerkörper, der eine Solenoid-Spule als Messspule trägt, sowie einer Zuführung zur Solenoid-Spule, über die ein Probenmaterial in ein von der Solenoid-Spule umschlossenes Messvolumen einbringbar ist zusammen setzt. Die Erfindung betrifft weiterhin ein Verfahren zum Betrieb eines derartigen Probenkopfes.

In der NMR-Spektroskopie wird eine Probe in einem starken statischen Grundmagnetfeld B₀ mit Hochfrequenz-Impulsen eines senkrecht zur Richtung des Grundmagnetfeldes gerichteten HF-Magnetfeldes beaufschlagt und die daraufhin von der Probe abgestrahlten HF-Impulse gemessen und ausgewertet. Zur Erzeugung möglichst starker und homogener Grundmagnetfelder werden heutzutage häufig supraleitende Magnetsysteme eingesetzt. Diese Magnetsysteme sind in der Regel vertikal angeordnet und weisen eine zentrale Bohrung auf, in die die anregende HF-Sende- und Empfangsspule mit der Probe eingebracht wird. Die Probe befindet sich dabei in dem von der Sende- bzw. Empfangsspule umschlossenen Messvolumen. Das System aus Probenaufnahme, Sende- und Empfangsspule sowie den entsprechenden elektrischen Zuführungen, die auf oder in einem Trägerkörper angeordnet sind, wird als Probenkopf bezeichnet. Dieser Probenkopf mit der Probenaufnahme und der Sende- bzw. Empfangsspule weist bei vielen NMR-Systemen eine an die Bohrung im supraleitenden Magneten angepasste längliche Form auf. Vor der Messung wird der Probenkopf aus der Magnetbohrung herausgenommen, ein mit dem Probenmaterial gefülltes Probenröhrchen in die Probenaufnahme eingesetzt und der Probenkopf wieder in die Bohrung des Magneten eingeschoben. Die Probenröhrchen ragen dabei in der Regel beidseitig über das Messvolumen hinaus, so dass stets eine größere Menge an Probenmaterial erforderlich ist als tatsächlich vermessen wird.

Aus der EP-A-0 730 164 ist ein Probenkopf für NMR-Messungen in einem Magnetsystem bekannt, das eine parallel zu einem Grundmagnetfeld verlaufende Bohrung für die Aufnahme des Probenkopfes aufweist, wobei der Probenkopf eine Solenoidspule als Messspule trägt. Über eine Zuführung wird z. B. eine Reiskorn in das Zentrum der Spule befördert und in einer Kammer für die NMR-Untersuchung festgehalten. Anschliessend wird es mittels komprimierter Luft in entgegengesetzter Richtung wieder entfernt.

Aus der DE 41 01 473 A1 ist ein Probenkopf für die Flüssigkeits-NMR-Spektroskopie bekannt, der eine automatisierte Serienmessung mehrerer Proben ermöglicht. In dem vorgeschlagenen Probenkopf ist ein beidseitig geöffnetes Probenröhrchen eingespannt, das mit Zuführungen für den Zufluss und den Abfluss der flüssigen Probe in den Probenkopf verbunden ist. Durch diese Zuführungen können abschnittsweise gewisse Volumina von Probenflüssigkeit in der so genannten Stop-Flow-Technik zugeführt werden. Auch eine kontinuierliche Betriebsweise des Probenkopfes ist bei dieser Druckschrift möglich. Durch eine geeignete Spannvorrichtung für das Probenröhrchen lässt sich dieses schnell auswechseln, so dass der Probenkopf mit Probenröhrchen unterschiedlicher Wandstärke oder unterschiedlichen Innenvolumens betrieben werden kann, ohne den vollständigen Probenkopf auswechseln zu müssen.

Ein Nachteil dieses Probenkopfes besteht jedoch im dem Einsatz einer Sattel-Messspule als HF-Sende- und Empfangsspule, da diese nur über einen Teil des von der Spule umschlossenen Volumens ein homogenes HF-Feld erzeugt. Gerade für die Untersuchung von gelösten Substanzen ist jedoch eine sehr gute HF-Homogenität erforderlich. Ein Wechsel der Probenröhrchen kann zudem dazu führen, dass der Füllfaktor der Messspule mit dem neuen Probenröhrchen nicht oder nicht mehr optimal ist. Ein weiterer Nachteil dieses bekannten Probenkopfes besteht darin, dass auch hier größere Probenmengen eingebracht werden müssen als dies für die eigentliche Messung erforderlich wäre. Bei der Vermessung unterschiedlicher Probenmaterialien ist zudem eine Spülung der Zuführungen erforderlich, um eine Vermischung unterschiedlicher Proben zu vermeiden.

Aus der DE 42 34 544 C2 ist ein Probenwechselsystem für Flüssigkeits-NMR-Spektroskopie bekannt, bei dem als Sende- und Empfangsspule auch eine Solenoid-Spule vorgeschlagen wird, wobei dann die Spulenachse sowie das Probenröhrchen senkrecht zur Bohrung des supraleitenden Grundfeldmagneten im Probenkopf angeordnet sind. Bei dem Probenkopf dieser Vorrichtung ist das Probenröhrchen ebenfalls mit entsprechenden Zuführungen für den Zufluss und den Abfluss des flüssigen Probenmaterials verbunden, so dass Messungen im Stop-Flow-Modus oder bei kontinuierlichem Durchfluss durchgeführt werden können. Auch bei diesem Probenkopf ergeben sich somit hinsichtlich des minimalen Probenvolumens sowie der Messung unterschiedlicher Proben die gleichen Nachteile wie bei der vorgenannten Druckschrift. Für die Vermessung von Proben, die einen anderen Innendurchmesser des Probenröhrchens erfordern, muss bei diesem System der gesamte Probenkopf ausgetauscht werden. Eine automatisierte Vermessung von Festkörperproben ist mit beiden Probenköpfen nicht möglich.

Ausgehend von diesem Stand der Technik besteht eine Aufgabe der vorliegenden Erfindung darin, einen Probenkopf sowie ein Verfahren zum Betrieb des Probenkopfes anzugeben, mit denen sich auf einfache Weise automatisierte Serienmessungen unterschiedlicher Proben auch mit sehr kleinen Probenvolumina durchführen lassen. Weiterhin soll der Probenkopf auch die automatisierte Messung von Festkörperproben sowie in einer besonderen Ausgestaltung eine einfache Optimierung des Füllfaktors bei unterschiedlichen Probenvolumina ermöglichen.

### Darstellung der Erfindung

Die Aufgabe wird mit dem Probenkopf sowie dem Verfahren gemäß Patentanspruch 1 bzw. 12 gelöst. Vorteilhafte Ausgestaltungen des Probenkopfes sowie des Verfahrens sind Gegenstand der Unteransprüche oder lassen sich aus der nachfolgenden Beschreibung und den Ausführungsbeispielen entnehmen.

Der vorliegende Probenkopf besteht in bekannter Weise aus einem Trägerkörper, der eine Solenoid-Spule als Messspule trägt, sowie einer Zuführung zur Solenoid-Spule, über die ein Probenmaterial in ein von der Solenoid-Spule umschlossenes Messvolumen einbringbar ist. Der Trägerkörper kann beispielsweise länglich ausgestaltet sein, wobei dann die Spulenachse der Solenoid-Spule vorzugsweise senkrecht zur Längsachse des Trägerkörpers ausgerichtet ist. Die Zuführung zur Solenoid-Spule ist beim vorliegenden Probenkopf für die Aufnahme und den Transport von Probenbehältnissen ausgebildet. Sie muss daher einen ausreichenden Innendurchmesser für die Aufnahme der Probenbehältnisse aufweisen. Eine derartige Zuführung kann beispielsweise rohr- oder schlauchförmig ausgebildet sein, ist durch die Solenoid-Spule hindurchgeführt und besteht zumindest innerhalb der Solenoid-Spule aus einem NMR-Material. Die zu vermessende Probe wird dann in ein geeignetes Probenbehältnis eingefüllt, in der Zuführung bis in das Messvolumen transportiert, dort vermessen und anschließend wieder aus dem Messvolumen abtransportiert. Die Probenbehältnisse können dabei so gewählt werden, dass sie nur die minimal für die Messung erforderliche Probenmenge aufnehmen. Der Durchmesser des Probenbehältnisses ist dabei an den Innendurchmesser der Zuführung angepasst, um einen problemlosen Transport innerhalb der Zuführung zu ermöglichen.

Durch diese Ausgestaltung des Probenkopfes ist in einfacher Weise eine automatisierte Serienmessung von beliebigen Probenmaterialien möglich. So können die Probenbehältnisse sowohl mit flüssigen, mit festen als auch mit gasförmigen Probenmaterialien gefüllt und diese Proben automatisiert vermessen werden. Durch Einsatz von in Zuführungsrichtung kurzen Probenbehältnissen lassen sich auch sehr kleine Probenvolumina vermessen.

Vorzugsweise ist die Solenoid-Spule lösbar mit dem Trägerkörper verbunden, so dass sie jederzeit einfach auswechselbar ist. Durch diese lösbare Verbindung der Solenoid-Spule mit dem Trägerkörper des Probenkopfes ist es möglich, eine Vielzahl von Solenoid-Spulen mit unterschiedlichen Durchmessern verfügbar zu halten und bei Bedarf im Probenkopf einzusetzen. Durch die einfache Auswechselbarkeit lässt sich das Messvolumen auf einfache Weise so an die jeweils zu vermessenden Probenvolumina anpassen, dass der Füllfaktor optimal ist und damit ein sehr gutes Signal-Rausch-Verhältnis erzielt wird. Der Einsatz von Solenoid-Spulen anstelle von häufig eingesetzten Helmholtz-Typ-Spulen oder Sattelspulen hat zudem den Vorteil, dass die HF-Homogenität über das Probenvolumen in der Solenoid-Spule ausgezeichnet ist. Solenoid-Spulen sind zudem einfach und kostengünstig herzustellen. In der bevorzugten Ausführungsform des vorliegenden Probenkopfes ist die Verbindung zwischen den Solenoid-Spulen und dem Trägerkörper als Steck-Verbindung ausgebildet, so dass der Spulen-Wechsel lediglich durch Abstecken einer Spule und Aufstecken der jeweils gewünschten anderen Spule vollzogen werden kann. Die SteckVerbindungen bilden hierbei vorzugsweise gleichzeitig die elektrische Kontaktierung zwischen den HF-Leitungen und der Spule. Selbstverständlich lässt sich die lösbare Verbindung jedoch auch in anderer Weise, beispielsweise als Klemmverbindung realisieren.

Vorzugsweise ist die Zuführung mit einem geeigneten Transportmechanismus verbunden, der einen schrittweisen Transport der Probenbehältnisse in der Zuführung ermöglicht. Hierzu können beispielsweise vor einer Messung eine Vielzahl von zu vermessenden Probenbehältnissen hintereinander in einen entsprechenden Sammelbereich der Zuführung eingebracht werden. Mit Hilfe des Transportmechanismus wird diese Reihe von Probenbehältnissen dann schrittweise so weitertransportiert, dass sich bei jedem Schritt eines der Probenbehältnisse im Messvolumen befindet und dort vermessen werden kann. Im nächsten Schritt wird das jeweils bereits vermessene Probenbehältnis aus dem Messvolumen transportiert und das Nachfolgende durch die Transportbewegung in das Messvolumen eingebracht.

Für den Transportmechanismus kommen unterschiedliche Techniken in Frage. So können die Probenbehältnisse beispielsweise mittels Luft oder einem anderen geeigneten Treibmittel in der Zuführung weitertransportiert werden. Auch ein mechanischer Schieber, der die Probenbehältnisse in der Zuführung verschiebt, ist selbstverständlich geeignet.

Durch diese Ausgestaltung des vorliegenden Probenkopfes lässt sich eine automatisierte Messung vieler Proben, insbesondere auch von Feststoffproben, im Routinebetrieb von Großlaboratorien durchführen. Durch geeignete Wahl der Größe der Probenbehältnisse lassen sich auch sehr kleine Probenvolumina vermessen, die vorzugsweise an die Größe des Messvolumens angepasst sind, und so die Kosten für das Probenmaterial reduzieren. Durch die Verwendung von kleinen Probenbehältnissen, die hintereinander in die Zuführung eingebracht werden können, wird auf vorteilhafte Weise eine Vermessung unterschiedlicher Proben in schnellem Wechsel ermöglicht, ohne hierfür die Zuführungen aufwendig spülen zu müssen.

### Kurze Beschreibung der Zeichnungen

Die vorliegende Erfindung wird nachfolgend anhand eines Ausführungsbeispiels in Verbindung mit den Zeichnungen ohne Beschränkung des allgemeinen Erfindungsgedankens nochmals kurz erläutert. Hierbei zeigen:
- Fig. 1: eine prinzipielle Darstellung des Einsatzes eines NMR-Probenkopfes in einem supraleitenden Grundfeldmagneten;
- Fig. 2: ein Beispiel für die Ausgestaltung des Probenkopfes gemäß der vorliegenden Erfindung in einer Teilansicht; und
- Fig. 3: ein Beispiel für den Verlauf der Zuführungen beim Probenkopf der vorliegenden Erfindung.

### Wege zur Ausführung der Erfindung

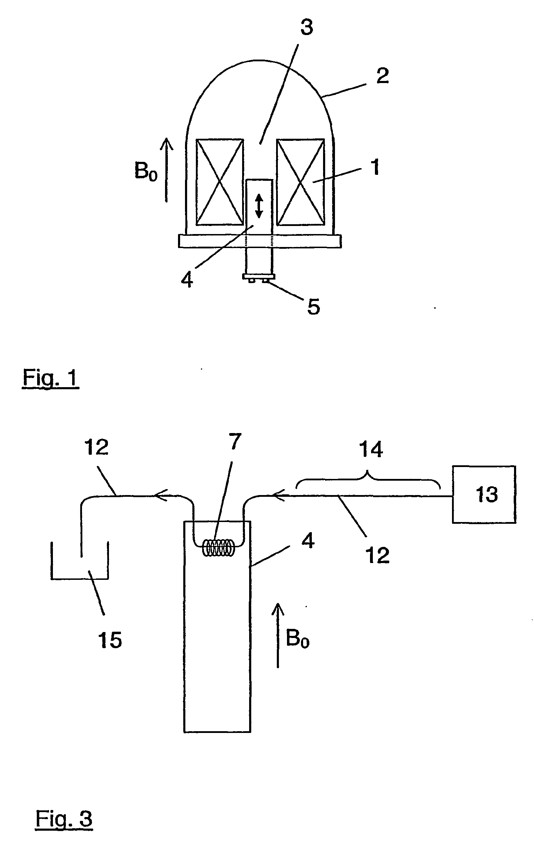

Fig. 1 zeigt beispielhaft eine typische Anordnung für die NMR-Spektroskopie mit einem supraleitenden Grundfeldmagneten 1. Dieser supraleitende Grundfeldmagnet 1 ist vertikal in einem Dewar-Gefäß 2 angeordnet und weist eine zentrale Bohrung 3 für das Einbringen der zu vermessenden Probe auf. In dieser Bohrung 3 herrscht ein sehr homogenes statisches Magnetfeld B₀, dessen Richtung in der Figur angedeutet ist. Zur Vermessung einer Probe wird diese einem Probenkopf 4 zugeführt, der in die Bohrung des Grundfeldmagneten 1 eingeführt wird. Dies ist in der Fig.1 schematisch mit dem Doppelpfeil angedeutet. Der Probenkopf 4 weist an seinem aus dem Grundfeldmagneten 1 herausstehenden Ende entsprechende Anschlüsse 5 für die HF-Versorgung der integrierten Sende- und Empfangsspule bzw. für die Weiterleitung der empfangenen Signale auf. Ein derartiger Probenkopf 4 beinhaltet in der Regel eine Anpassungsschaltung zur Anpassung des Probenkopfes auf den üblichen Eingangswiderstand von 50 Q am Eingang des Probenkopfes sowie einen mit der Messspule verbundenen Leitungsresonator, der an die Sendefrequenz angepasst ist. Diese Komponenten sind nicht Gegenstand der vorliegenden Erfindung und daher im vorliegenden Ausführungsbeispiel auch nicht explizit gezeigt. Sie können in der dem Fachmann bekannten Weise wie bei anderen bekannten Probenköpfen ausgebildet sein.

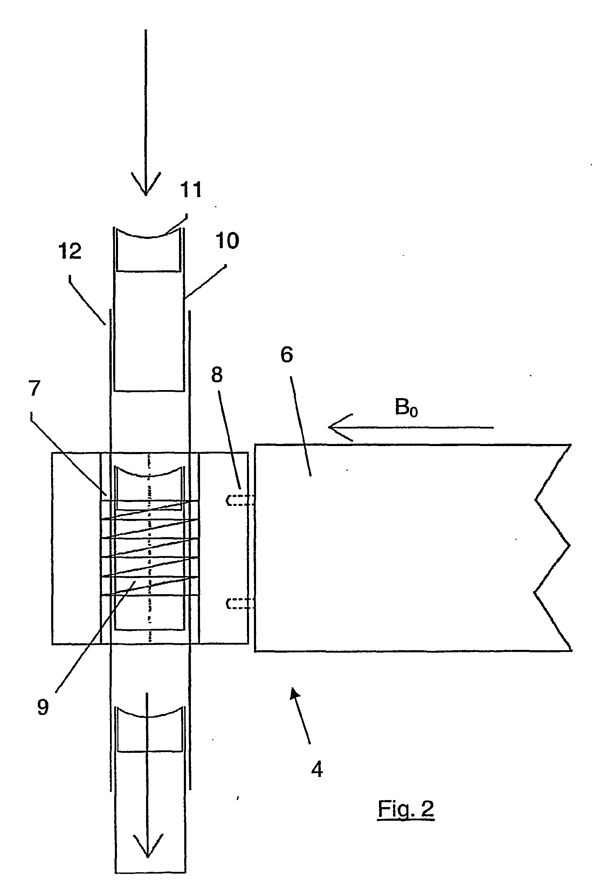

Fig. 2 zeigt ein Beispiel einer Ausgestaltung des erfindungsgemäßen Probenkopfes im Massstab von annähernd 1:1, wobei in dieser Darstellung nur der vordere Bereich des Probenkopfes 4 dargestellt ist. In diesem vorderen Bereich, der sich bei der Messung im Zentrum der Bohrung 3 des supraleitenden Grundfeldmagneten 1 befindet, ist der Trägerkörper 6 des Probenkopfes 4 zu erkennen, auf den eine Solenoid-Spule 7 aufgesteckt ist. Die Steck-Verbindung 8 ist in dieser Figur lediglich schematisch angedeutet. Das von der Solenoid-Spule 7 umschlossene Messvolumen 9 wird durch den Durchmesser der Spule 7 sowie deren Längserstreckung festgelegt. Zur Veränderung der Dimensionen dieses Messvolumens 9 lässt sich ein Satz von mehreren Solenoid-Spulen 7 mit unterschiedlichen Längen und Durchmessern bereithalten, die sich in gleicher Weise auf den Trägerkörper 6 aufstecken lassen. Auf diese Weise lässt sich die Solenoid-Spule 7 am Probenkopf 4 jederzeit einfach austauschen und zur Erzielung eines optimalen Füllfaktors jeweils an die Dimensionen der Probenvolumina anpassen.

Die Probenmaterialien werden in Probenbehältnisse 10 eingefüllt, die im vorliegenden Beispiel aus kurzen Röhrchen aus einem die NMR-Messung nicht störenden Material bestehen und mit einem Stopfen 11, beispielsweise aus Teflon, wasser- und luftdicht verschlossen werden. Zum Transport dieser Probenbehältnisse 10 wird im vorliegenden Beispiel ein Rohr bzw. Schlauch 12 eines geeigneten Durchmessers durch die Solenoid-Spule 7 geführt, in dem die Probenbehältnisse 10 transportiert werden können. Diese Ausgestaltung ermöglicht es, eine große Anzahl von Probenbehältnissen 10 mit verschiedenen Proben in den Schlauch 12 einzuführen und nach jeder Messung einer speziellen Probe, d.h. einer Probe in einem der Probenbehältnisse 10, das Probenbehältnis 10 durch einen Luftstrom aus der Solenoid-Spule 7 zu befördern und die nächste Probe im jeweiligen Probenbehältnis 10 einzubringen. Als Transportmittel kann auch eine Flüssigkeit verwendet werden, um beispielsweise eine Suszeptibilitäts-Anpassung im Messvolumen 9 zu erreichen.

Diese Möglichkeit des automatischen Probenwechsels ist im Vergleich zu herkömmlichen Probenwechslern, die einzelne NMR-Röhrchen vertikal in den NMR-Probenkopf einführen, wesentlich kostengünstiger und robuster. Insbesondere lassen sich bei der vorliegenden Ausgestaltung des Probenkopfes bzw. dem vorliegenden Verfahren mehrere Probenbehältnisse 10 mit unterschiedlichen Proben in einen entsprechenden Sammelabschnitt 14 des Schlauches 12 einführen, von dem aus die Probenbehältnisse 10 zur Messung dann schrittweise durch das Messvolumen 9 transportiert werden.

Fig. 3 zeigt beispielhaft einen Verlauf des Rohres bzw. Schlauches 12 des Probenkopfes 4, wobei die Solenoid-Spule 7 am vorderen Ende des Probenkopfes 4 angedeutet ist. Der Schlauch 12 ist mit einer Transportvorrichtung 13 verbunden, die die in einem Sammelabschnitt 14 zwischen der Transportvorrichtung 13 und dem Probenkopf 4 zunächst hintereinander eingebrachten Probenbehältnisse 10 zur Messung durch das Messvolumen des Probenkopfes 4 transportiert. Der Probenkopf 4 muss hierzu nicht aus der Bohrung 3 des supraleitenden Grundfeldmagneten 1 herausgenommen werden. Die bereits vermessenen Proben werden am anderen Ende des Schlauches 12 in eine entsprechende Sammelstation 15 ausgegeben.

### BEZUGSZEICHENLISTE

| | |
|---|---|
| 1 | Supraleitender Grundfeldmagnet |
| 2 | Dewar-Gefäß |
| 3 | Bohrung im Grundfeldmagneten |
| 4 | Probenkopf |
| 5 | Anschlüsse des Probenkopfes |
| 6 | Trägerkörper |
| 7 | Solenoid-Spule |
| 8 | Steck-Verbindung |
| 9 | Messvolumen |
| 10 | Probenbehältnisse |
| 11 | Stopfen |
| 12 | Rohr bzw. Schlauch |
| 13 | Transportvorrichtung |
| 14 | Sammelstrecke |
| 15 | Sammelstation |

## Patentansprüche

1. Probenkopf für NMR-Messungen in einem Magnetsystem, das eine parallel zu einem Grundmagnetfeld verlaufende Bohrung für die Aufnahme des Probenkopfes aufweist, wobei sich der Probenkopf aus einem Trägerkörper (6), der eine Solenoid-Spule (7) als Messspule trägt, sowie einer Zuführung (12) in Form einer Transportleitung zur Solenoid-Spule (7), über die ein Probenmaterial in ein von der Solenoid-Spule (7) umschlossenes Messvolumen (9) einbringbar ist, zusammen setzt,
**dadurch gekennzeichnet,**
**dass** die Zuführung (12) für die Aufnahme und den Transport von Probenbehältnissen (10) durch das Messvolumen (9) hindurch ausgebildet ist, und sie dazu derart ausgestaltet ist, daß nach Einbringen des Probenkopfs in das Magnetsystem die Probenbehältnisse nacheinander entlang der Bohrung zur Solenoidspule und entlang dieser durch sie hindurch geführt werden.

2. Probenkopf nach Anspruch 1,
**dadurch gekennzeichnet,**
**dass** die Solenoid-Spule (7) lösbar mit dem Trägerkörper (6) verbunden ist.

3. Probenkopf nach Anspruch 2,
**dadurch gekennzeichnet,**
**dass** die lösbare Verbindung zwischen dem Trägerkörper (6) und der Solenoid-Spule (7) als Steckverbindung (8) ausgebildet ist.

4. Probenkopf nach einem der Ansprüche 1 bis 3,
**dadurch gekennzeichnet,**
**dass** die Zuführung (12) für die Aufnahme von mehreren hintereinander angeordneten Probenbehältnissen (10) ausgebildet ist.

5. Probenkopf nach einem der Ansprüche 1 bis 4,
**dadurch gekennzeichnet,**
**dass** die Zuführung (12) mit einem Transportmechanismus (13) verbunden ist, der einen schrittweisen Transport der Probenbehältnisse (10) in der Zuführung (12) ermöglicht.

6. Probenkopf nach Anspruch 5,
**dadurch gekennzeichnet,**
**dass** der Transportmechanismus (13) den Transport durch Einpressen von Luft oder anderen Treibmitteln in die Zuführung (12) ausführt.

7. Probenkopf nach einem der Ansprüche 1 bis 6,
**dadurch gekennzeichnet,**
**dass** der Probenkopf Probenbehältnisse (10) umfasst, die so dimensioniert sind, dass sie vollständig in das Messvolumen (9) einbringbar sind.

8. Probenkopf nach einem der Ansprüche 1 bis 6,
**dadurch gekennzeichnet,**
**dass** der Probenkopf Probenbehältnisse (10) umfasst, die für die Aufnahme eines maximalen Probenvolumens von s 1 ml ausgebildet sind.

9. Probenkopf nach einem der Ansprüche 1 bis 8,
**dadurch gekennzeichnet,**
**dass** die Zuführung (12) von einer Aufnahmeöffnung des Probenkopfes (4) für die Probenbehältnisse (10) vollständig durch das Messvolumen (9) hindurch bis zu einer Ausgabeöffnung des Probenkopfes (4) für die Probenbehältnisse (10) geführt ist.

10. Probenkopf nach einem der Ansprüche 1 bis 9,
**dadurch gekennzeichnet,**
**dass** die Zuführung (12) rohr- oder schlauchförmig ausgebildet ist.

11. Probenkopf nach einem der Ansprüche 1 bis 10 mit mehreren Solenoid-Spulen (7) unterschiedlicher Größe, die wechselseitig mit dem Trägerkörper (6) verbindbar sind.

12. Verfahren zum Betrieb eines Probenkopfes nach einem der Ansprüche 1 bis 10, bei dem das Probenmaterial in ein Probenbehältnis (10) eingefüllt, das Probenbehältnis (10) in die Zuführung (12) eingebracht, in der Zuführung (12) in einer Transportrichtung zum Messvolumen (9) transportiert und nach der Messung über die Zuführung (12) in der gleichen Transportrichtung wieder aus dem Messvolumen (9) abtransportiert wird.

13. Verfahren Anspruch 12, bei dem das Probenbehältnis (10) mit einem Treibmittel in der Zuführung (12) transportiert wird.

14. Verfahren Anspruch 12 oder 13, bei dem mehrere Probenbehältnisse (10) mit dem gleichen oder mit unterschiedlichen Probenmaterialien zunächst hintereinander in die Zuführung (12) eingebracht und anschließend gemeinsam in der Zuführung (12) schrittweise transportiert werden, um sie nacheinander zu vermessen.

## Claims

1. Probe head for NMR measurements in a magnetic system comprising a bore for receiving the probe head, which extends in parallel with a base magnetic field, with the probe head consisting of a support body (6) carrying a solenoid coil (7) as measuring coil, as well as of a feed line (12) in the form of a conveying line towards the solenoid coil (7), via which a sample material can be introduced into a measuring volume (9) surrounded by said solenoid coil (7),
**characterised in**
**that** said feed line (12) is configured for receiving and conveying sample containers (10) through said measuring volume (9), and is so designed, to this end, that after introduction of said probe head into the magnetic system, said sample containers are guided, in succession, along said bore to said solenoid coil and along the coil through the latter.

2. Probe head according to Claim 1,
**characterised in**
**that** said solenoid coil (7) is detachably connected to said support body (6).

3. Probe head according to Claim 2,
**characterised in**
**that** said detachable connection is configured between said support body (6) and said solenoid coil (7) as plug-and-socket connector (8).

4. Probe head according to any of the Claims 1 to 3,
**characterised in**
**that** said feed line (12) is configured for receiving several sample containers (10) disposed in succession.

5. Probe head according to any of the Claims 1 to 4,
**characterised in**
**that** said feed line (12) is connected to a conveying mechanism (13) that permits stepwise conveyance of said sample containers (10) in said feed line (12).

6. Probe head according to Claim 5,
**characterised in**
**that** said conveying mechanism (13) realises the transport by pressing in air or other propelling agents into said feed line (12).

7. Probe head according to any of the Claims 1 to 6,
**characterised in**
**that** the probe head includes sample containers (10) so dimensioned that they can be completely introduced into said measuring volume (9).

8. Probe head according to any of the Claims 1 to 6,
**characterised in**
**that** the probe head includes sample containers (10) configured for receiving a maximum sample volume of ≤ 1 ml.

9. Probe head according to any of the Claims 1 to 8,
**characterised in**
**that** said feed line (12) is passed from a receiving opening of said probe head (4) for said sample containers (10) completely through said measuring volume (9) up to a discharge opening of said probe head (4) for said sample containers (10).

10. Probe head according to any of the Claims 1 to 9,
**characterised in**
**that** said feed line (12) presents a tubular configuration.

11. Probe head according to any of the Claims 1 to 10, comprising several solenoid coils (7) of different size, which can be connected to said support body (6) in alternation.

12. Method of operating a probe head according to any of the Claims 1 to 10, wherein the sample material is charged into a sample container (10), said sample container (10) is introduced into said feed line (12), is conveyed in said feed line (12) towards said measuring volume (9) and, after measurement, is conveyed again via said feed line (12) out of said measuring volume (9) along the same conveying direction.

13. Method according to Claim 12, wherein said sample container (10) is conveyed by means of a propelling agent in said feed line (12).

14. Method according to Claim 12 or 13, wherein several sample containers (10) with the same or with different sample materials are initially introduced in succession into said feed line (12) and are subsequently conveyed together in steps in said feed line (12) for measuring them in succession.

## Revendications

1. Tête porte-échantillon pour le mesurage RMN dans un système magnétique comprenant un alésage à recevoir la tête porte-échantillon, qui s'étend en parallèle à un champ magnétique de base, à la tête porte-échantillon étant constitué d'un corps de support (6) portant une bobine de solénoïde (7) en tant que bobine de mesure, ainsi que d'un passage d'amenée (12) sous forme d'un passage de transport vers la bobine de solénoïde (7), via lequel un matériel échantillon peut s'introduire dans un volume de mesure (9) enfermé par ladite bobine de solénoide (7),
**caractérisé en ce**
**que** ledit passage d'amenée (12) est configuré de façon à recevoir et acheminer des récipients d'échantillon (10) à travers ledit volume de mesure (9), en étant conçu d'une telle manière, à cette fin, qu'après l'entrée de ladite tête porte-échantillon dans le système magnétique, lesdits récipients d'échantillon sont guidés, l'un derrière l'autre, le long dudit alésage vers ladite bobine de solénoïde et le long de la bobine à travers de la dernière.

2. Tête porte-échantillon selon la revendication 1,
**caractérisé en ce**
**que** ladite bobine de solénoïde (7) est reliée, de façon amovible, audit corps de support (6).

3. Tête porte-échantillon selon la revendication 2,
**caractérisé en ce**
**que** ladite connexion amovible est configurée entre ledit corps de support (6) et ladite bobine de solénoïde (7) sous forme d'un connecteur enfichable (8).

4. Tête porte-échantillon selon une quelconque des revendications 1 à 3,
**caractérisé en ce**
**que** ledit passage d'amenée (12) est configuré de manière à recevoir plusieurs récipients d'échantillon (10) disposés l'un derrière l'autre.

5. Tête porte-échantillon selon une quelconque des revendications 1 à 4,
**caractérisé en ce**
**que** ledit passage d'amenée (12) est relié à un mécanisme de transport (13), qui permet l'avance intermittente desdits récipients d'échantillon (10) dans ledit passage d'amenée (12).

6. Tête porte-échantillon selon la revendication 5,
**caractérisé en ce**
**que** ledit mécanisme de transport (13) effectue le transport en pressant de l'air ou des autres agents propulseurs dans ledit passage d'amenée (12).

7. Tête porte-échantillon selon une quelconque des revendications 1 à 6,
**caractérisé en ce**
**que** la tête porte-échantillon comprend des récipients d'échantillon (10) si dimensionnés, qu'ils puissent entrer complètement dans ledit volume de mesure (9).

8. Tête porte-échantillon selon une quelconque des revendications 1 à 6,
**caractérisé en ce**
**que** la tête porte-échantillon comprend des récipients d'échantillon (10) configurés de façon à recevoir un volume maximal d'échantillon de ≤ 1 ml.

9. Tête porte-échantillon selon une quelconque des revendications 1 à 8,
**caractérisé en ce**
**que** ledit passage d'amenée (12) s'étend d'une ouverture d'entrée de ladite tête porte-échantillon (4) pour lesdits récipients d'échantillon (10) complètement à travers ledit volume de mesure (9) jusqu'à une ouverture de sortie de ladite tête porte-échantillon (4) pour lesdits récipients d'échantillon (10).

10. Tête porte-échantillon selon une quelconque des revendications 1 à 9,
**caractérisé en ce**
**que** ledit passage d'amenée (12) présente une configuration tubulaire.

11. Tête porte-échantillon selon une quelconque des revendications 1 à 10, comprenant plusieurs bobines de solénoïde (7) de dimensions différentes, qui sont aptes à être relié audit corps de support (6) alternativement d'un côté à l'autre.

12. Procédé à opérer une tête porte-échantillon selon une quelconque des revendications 1 à 10, dans lequel le matériel échantillon est chargé dans un récipient d'échantillon (10), ledit récipient d'échantillon (10) est introduit dans ledit passage d'amenée (12), est transporté dans ledit passage d'amenée (12) vers ledit volume de mesure (9) et est transporté, après le mesurage, encore via ledit passage d'amenée (12) en dehors dudit volume de mesure (9) le long la même direction de transport.

13. Procédé selon la revendication 12, dans lequel ledit récipient d'échantillon (10) est transporté moyennant un agent propulseur dans ledit passage d'amenée (12).

14. Procédé selon la revendication 12 ou 13, dans lequel plusieurs récipients d'échantillon (10) au même matériel ou aux matériels échantillons différents sont d'abord introduit, l'un derrière l'autre, dans ledit passage d'amenée (12) et sont ensuite transporté ensemble, par avance intermittente, dans ledit passage d'amenée (12) pour leur mesurage en phases successives.
